# DEMANDE DE BREVET EUROPEEN

(11) **EP 4 671 735 A1**
(43) Date de publication de la demande: **31.12.2025**
(21) Numéro de dépôt: 25186103.5
(22) Date de dépôt: 29.06.2025
(51) Int. Cl.: G01N 21/17, G01N 29/02, G01N 29/22, G01N 29/24

(54) **PROCÉDÉ DE FABRICATION D'UNE ENCEINTE D'UN DISPOSITIF DE DÉTECTION PHOTOACOUSTIQUE**

(30) Priorité: 30.06.2024 FR 2407122
(71) Demandeur: Commissariat à l'Energie Atomique et aux Energies Alternatives, 75015 Paris (FR)
(72) Inventeur: BRIA, Toufiq, 38054 GRENOBLE CEDEX 09 (FR); JOURDE, Kévin, 38054 GRENOBLE CEDEX 09 (FR); BARNOLA, Sébastien, 38054 GRENOBLE CEDEX 09 (FR)
(74) Mandataire: INNOV-GROUP

(57) **Abrégé**

Procédé de fabrication d'une enceinte (2) délimitant une cavité (4), l'enceinte étant destinée à être appliquée contre un échantillon à analyser (E), la cavité étant configurée pour s'étendre entre l'échantillon et un transducteur acoustique (T), la cavité débouchant sur une face de contact (3) destinée à être appliquée contre l'échantillon, l'enceinte comportant :
- une ouverture de contact (3o), ménagée dans la face de contact, débouchant dans la cavité ;
- une membrane (5) s'étendant à travers la cavité, en regard de la face de contact, de façon que tout ou partie de la cavité s'étend entre la membrane et un capot (2c);
le procédé comportant les étapes de microstructuration de trois substrats, de façon à former le capot (2c), la partie arrière (4r) de la cavité, la membrane (5) et la partie avant (4a) de la cavité.

## Description

### DOMAINE TECHNIQUE

Le domaine technique de l'invention est la fabrication d'un dispositif de détection d'un analyte par effet photoacoustique. La fabrication est réalisée par des étapes de microfabrication collective sur des substrats mises en œuvre dans le domaine de la microélectronique.

### ART ANTERIEUR

La détection photoacoustique est basée sur la détection d'une onde acoustique générée sous l'effet de l'absorption, par un milieu analysé, d'une onde incidente électromagnétique impulsionnelle ou modulée en amplitude. L'onde acoustique est formée suite à un échauffement de molécules d'intérêt, présentes dans le milieu analysé, sous l'effet de l'absorption de l'onde incidente. L'échauffement entraîne une dilatation thermique modulée du milieu, cette dernière étant à l'origine de l'onde acoustique.

La détection photoacoustique peut être spécifique à un analyte particulier, en ajustant la longueur d'onde de l'onde incidente électromagnétique à une longueur d'onde d'absorption de l'analyte. La détection photoacoustique a été ainsi été appliquée pour détecter des espèces gazeuses dans un gaz, ou pour détecter la présence de molécules particulières dans des tissus biologiques. La longueur d'onde de l'onde incidente se situe fréquemment dans l'infra-rouge.

La détection photoacoustique constitue alors une technique d'analyse non invasive, pouvant être mise en œuvre dans des milieux diffusants ou opaques.

Le brevet US11774347 décrit un dispositif de détection photoacoustique comportant une enceinte destinée à être appliquée contre un échantillon à analyser. L'enceinte délimite une cavité, débouchant sur une face de contact, cette dernière étant configurée pour être disposée au contact de l'échantillon. Le dispositif comporte une membrane, s'étendant dans l'enceinte, et destinée à retenir l'humidité et à transmettre une onde photoacoustique, émise par l'échantillon.

WO2023118611 décrit un dispositif de détection photoacoustique comportant une enceinte destinée à être appliquée contre un échantillon à analyser. L'enceinte comportant une membrane destinée former une interface entre le milieu à analyser.

Le brevet US11674931 décrit un dispositif de détection photoacoustique comportant une enceinte destinée à être appliquée contre un échantillon à analyser. L'enceinte délimite une cavité, débouchant sur une face de contact, cette dernière étant configurée pour être disposée au contact de l'échantillon. Le dispositif comporte un tube, s'étendant, à partir de la cavité, vers l'extérieur de la cavité. Le tube forme un évent du dispositif. Les dimensions du tube sont adaptées au volume de la cavité, de façon à optimiser les performances du dispositif.

Les inventeurs proposent un procédé permettant de fabriquer un dispositif présentant des caractéristiques telles que décrites dans US11774347 et/ou US11674931, en mettant en œuvre des procédés de microfabrication collective. Le procédé décrit ci-après permet de réaliser, de façon simple, un dispositif de détection par effet photoacoustique, en tirant profit de la capacité de la microélectronique à obtenir simultanément un grand nombre de dispositifs.

### EXPOSE DE L'INVENTION

Un premier objet de l'invention est un procédé de fabrication d'une enceinte délimitant une cavité, de préférence creuse, l'enceinte étant destinée à être appliquée contre un échantillon à analyser, la cavité étant configurée pour s'étendre entre l'échantillon et un transducteur acoustique, la cavité débouchant sur une face de contact destinée à être appliquée contre l'échantillon, l'enceinte comportant :
- une ouverture de contact, ménagée dans la face de contact, débouchant dans la cavité ;
- une membrane s'étendant à travers la cavité, en regard de la face de contact, de façon que tout ou partie de la cavité s'étend entre la membrane et un capot;
le procédé comportant les étapes :
- 1) microstructuration d'un premier substrat, de façon à former le capot;
- 2) microstructuration d'un deuxième substrat, de façon à former une partie arrière de l'enceinte, délimitant tout ou partie de la cavité, entre la membrane et le capot ;
- 3) microstructuration d'un troisième substrat, de façon à former une partie avant de l'enceinte, comportant la membrane;
- 4) assemblage du capot sur la partie arrière de l'enceinte, et de la partie arrière de l'enceinte sur la partie avant de l'enceinte.

Selon une possibilité, la membrane sépare la cavité entre une partie arrière de la cavité et une partie avant de la cavité, la partie avant de la cavité débouchant sur la face de contact, la membrane étant disposée entre la partie avant de la cavité et la partie arrière de la cavité. De préférence, la partie avant et la partie arrière de la cavité sont creuses.

L'étape 2) peut comporter une formation de la partie arrière de la cavité.

L''étape 3) peut comporter une formation de la partie avant de la cavité.

L'étape 1) peut comporter une formation d'un canal acoustique s'étendant à travers le capot, destiné à relier la cavité au transducteur acoustique.

L'étape 1) peut comporter une formation d'un évent s'étendant à travers le capot, destiné à relier la cavité à un milieu extérieur à cette dernière.

L'étape 1) peut comporter une formation d'un canal de détection, s'étendant à travers le capot, destiné à relier la cavité à un capteur de température et/ou d'humidité.

Selon une possibilité:
- le premier substrat comporte une première couche supérieure, une première couche intermédiaire, de type isolant, et une première couche inférieure ;
- l'étape 1) comporte
   - 1i) gravure de la première couche inférieure, de façon à former au moins une première ouverture inférieure, la première couche intermédiaire faisant office de couche d'arrêt de gravure ;
   - 1ii) gravure de la première couche supérieure, de façon à former au moins une première ouverture supérieure, la première couche intermédiaire faisant office de couche d'arrêt de gravure ;
   - 1iii) retrait de la première couche intermédiaire, respectivement entre chaque première ouverture inférieure formée lors de la sous-étape 1i) et chaque première ouverture supérieure formée lors de la sous-étape 1ii), formée lors de la sous-étape 1ii), de façon à former un canal, choisi parmi le canal acoustique, l'évent ou le canal de détection.

De préférence, lors des étapes 1i) et 1ii), on forme respectivement au moins deux ou trois ouvertures inférieures et au moins deux ou trois ouvertures supérieures, de façon à former deux ou trois canaux, lors de l'étape 1iii), chaque canal correspondant à un canal choisi parmi le canal acoustique, l'évent ou le canal de détection.

La première couche intermédiaire peut être formée d'un matériau isolant, la première couche supérieure et la première couche inférieure étant formées d'un matériau semi-conducteur. Selon une possibilité :
- le deuxième substrat comporte une deuxième couche supérieure, une deuxième couche intermédiaire, et une deuxième couche inférieure;
- l'étape 2) comporte les sous-étapes suivantes :
   - 2i) gravure de la deuxième couche supérieure, de façon à former une deuxième ouverture supérieure, la deuxième couche intermédiaire faisant office de couche d'arrêt de gravure ;
   - 2ii) gravure de la deuxième couche inférieure, de façon à former une deuxième ouverture inférieure, la deuxième couche intermédiaire faisant office de couche d'arrêt de gravure ;
   - 2iii) retrait de la deuxième couche intermédiaire, respectivement entre la deuxième ouverture supérieure formée lors de la sous-étape 2i) et la deuxième ouverture inférieure formée lors de la sous-étape 2ii), de façon à former tout ou partie de la cavité.

Selon une possibilité :
- le deuxième substrat s'étend parallèlement à un plan principal;
- lors de l'étape 2i), la gravure est réalisée, à travers la deuxième couche supérieure, selon une dimension supérieure, dans le plan principal ;
- lors de l'étape 2ii), la gravure est réalisée, à travers la deuxième couche inférieure, selon une dimension inférieure, dans le plan principal ;
- la dimension inférieure est plus élevée que la dimension supérieure.

L'épaisseur de la deuxième couche inférieure peut être plus élevée que l'épaisseur de la deuxième couche supérieure.

Selon une possibilité, la deuxième couche intermédiaire est formée d'un matériau isolant, la deuxième couche supérieure et la deuxième couche inférieure étant formées d'un matériau semi-conducteur.

Selon une possibilité, au cours de l'étape 2iii), le retrait de la deuxième couche intermédiaire forme la partie arrière de la cavité.

Selon une possibilité :
- le troisième substrat comporte une troisième couche supérieure, une troisième couche intermédiaire et une troisième couche inférieure;
- l'étape 3) comporte :
   - 3i) gravure de la troisième couche inférieure, de façon à former une partie avant de l'enceinte, la troisième couche intermédiaire faisant office de couche d'arrêt de gravure, la troisième couche supérieure formant la membrane.

Au cours de l'étape 3i), la gravure de la troisième couche inférieure peut former la partie avant de la cavité .

Selon une possibilité, la membrane est traversée par des ouvertures. Le procédé peut alors comporter :
- 3ii) gravure de la troisième couche supérieure, la troisième couche intermédiaire faisant office de couche d'arrêt de gravure, la gravure de la troisième couche supérieure étant configurée pour former une pluralité de troisièmes ouvertures s'étendant à travers la troisième couche supérieure ;
- 3iii) retrait de la troisième couche intermédiaire, au niveau de chaque troisième ouverture résultant de la sous-étape 3ii), de façon que chaque troisième ouverture soit traversante.

Selon une possibilité, chaque assemblage est réalisé par thermocompression.

Un deuxième objet de l'invention est une enceinte, délimitant une cavité, l'enceinte étant destinée à être appliquée contre un échantillon à analyser, la cavité étant configurée pour s'étendre entre l'échantillon et un détecteur acoustique, la cavité débouchant sur une face de contact destinée à être appliquée contre l'échantillon, l'enceinte comportant :
- une ouverture de contact, ménagée dans la face de contact, débouchant dans la cavité ;
- une membrane s'étendant à travers la cavité, en regard de la face de contact, de façon que tout ou partie de la cavité s'étend entre la membrane et un capot;
l'enceinte étant fabriquée en mettant en œuvre les étapes 1) à 4) du premier objet de l'invention.

Un troisième objet de l'invention est un dispositif comportant une enceinte, délimitant une cavité, l'enceinte étant destinée à être appliquée contre un échantillon à analyser, le dispositif comportant :
- une face de contact, débouchant dans la cavité, et destinée à être appliquée contre l' échantillon ;
- une source de lumière, configurée pour émettre une lumière impulsionnelle ou modulée en amplitude à travers l'enceinte, vers la face de contact ;
- un transducteur acoustique, relié à la cavité ;
- le dispositif étant tel que l'enceinte est une enceinte selon le deuxième objet de l'invention.

L'invention sera mieux comprise à la lecture de l'exposé des exemples de réalisation présentés, dans la suite de la description, en lien avec les figures listées ci-dessous.

### FIGURES

La figure 1 représente une vue d'ensemble d'un dispositif de détection photoacoustique.
Les figures 2A à 2T schématisent les étapes de mise en forme d'un premier substrat, destiné à former un capot du dispositif.
Les figures 3A à 3Q schématisent les étapes de mise en forme d'un deuxième substrat, destiné à former une partie arrière d'une enceinte du dispositif.
Les figures 4A à 4K schématisent les étapes de mise en forme d'un troisième substrat, destiné à former une partie avant d'une enceinte du dispositif.
Les figures 5A à 5D montrent les étapes d'assemblage du premier substrat, du deuxième substrat et du troisième substrat après leur mise en forme.

### EXPOSE DE MODES DE REALISATION PARTICULIERS

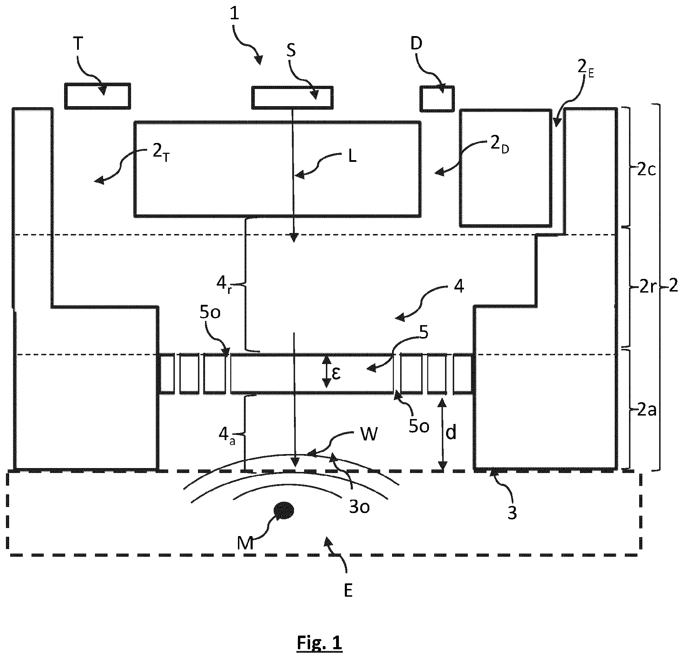

On a schématisé, sur la figure 1, un dispositif 1 permettant une mise en œuvre de l'invention. Le dispositif 1 est configuré pour être appliqué contre un échantillon E à analyser. Le dispositif comporte une face de contact 3, destinée à être appliquée contre l'échantillon à analyser. La face de contact est conçue pour se conformer à l'échantillon E contre laquelle elle est destinée à s'appuyer. Elle est par exemple plane.

Dans cet exemple, l'échantillon E est la peau d'un utilisateur. Le dispositif comporte une source de lumière S, configurée pour émettre un faisceau lumineux L se propageant jusqu'à l'échantillon E à analyser. La source de lumière S est impulsionnelle ou modulée en amplitude. Le faisceau lumineux L est émis dans une bande spectrale d'émission Δλ comportant une longueur d'onde d'absorption λₐ de molécules M présentes dans l'échantillon. Un objectif du dispositif 1 est de détecter la présence de de la molécule M et éventuellement d'en estimer une concentration.

La molécule M peut par exemple être du glucose, ou d'un analyte corporel de type cholestérol, triglycérides, urée, albumine, alcool (par exemple éthanol), tétrahydrocannabinol.

La bande spectrale d'émission Δλ s'étend de préférence dans le visible ou dans l'infra-rouge, par exemple entre des longueurs d'onde de 3 µm et de 15 µm. De préférence, la bande spectrale d'émission Δλ est suffisamment étroite, de façon que le dispositif 1 soit spécifique à un seul analyte. Lorsque l'analyte est le glucose, la bande spectrale d'émission est centrée sur une longueur d'onde d'absorption du glucose, par exemple correspondant à un nombre d'onde de 1034 cm⁻¹. La source de lumière S peut notamment être une source laser impulsionnelle, par exemple un laser accordable en longueur d'onde de type QCL (Quantum Cascade Laser). La bande spectrale d'émission Δλ est alors située dans l'infra-rouge.

Selon d'autres modes de réalisation, la source de lumière S peut être une source de type filament, ou une diode électroluminescente. Selon ces modes de réalisation, il est préférable d'associer la source de lumière S à un filtre passe-bande pour définir une bande spectrale d'émission suffisamment étroite, et centrée sur la longueur d'onde d'absorption considérée. Cependant, le recours à une source laser est préféré.

Le dispositif comporte une enceinte de confinement 2, disposée au contact de l'échantillon E, et délimitant une cavité 4. La cavité 4 débouche sur une ouverture de contact 3o ménagée dans la face de contact 3, l'ouverture de contact étant destinée à être appliquée face à l'échantillon E, de préférence au contact de ce dernier. Le faisceau lumineux L se propage jusqu'à l'échantillon E à travers la cavité 4, et l'ouverture de contact 3o.

Le dispositif comporte une membrane 5 s'étendant à travers la cavité 4, en regard de la face de contact 3, la membrane étant de préférence traversée par des ouvertures traversantes 5o. La membrane 5 sépare la cavité 4 en une partie avant 4a, comportant la face de contact 3, et une partie arrière 4r, s'étendant entre la membrane 5 et un capot 2c. Le capot 2c referme la cavité 4, en étant disposé en vis-à-vis de la membrane 5.

Sur la figure 1, on a matérialisé une segmentation de l'enceinte 2 en trois composantes :
- le capot 2c ;
- la partie arrière 2r, qui confine la partie arrière de la cavité 4r ;
- la partie avant 2a, qui comporte la membrane 5 et la face de contact 3.

Selon le procédé décrit par la suite, ces trois composantes sont réalisées séparément, et sont assemblées. Sur la figure 1, les lignes en pointillés matérialisent les séparations entre les trois composantes.

La membrane 5 peut être telle que décrite dans US11774347. La membrane 5 s'étend à l'intérieur de la cavité 4 , à une distance d non nulle de l'ouverture de contact 3o. En effet, lors de la mise en œuvre du dispositif, il est préférable que la membrane 5 ne soit pas en contact avec l'échantillon E. Le fait de disposer la membrane à distance permet de maintenir une couche d'air entre l'ouverture de contact 3o et la membrane 5. La distance entre la membrane et l'ouverture de contact est de préférence supérieure à 200 µm, ou 500 µm. L'épaisseur ε de la membrane 5 est de préférence comprise entre 100 µm et 1 mm, et de préférence entre 150 µm et 750 µm.

Lorsque la membrane 5 comporte des ouvertures traversantes 5o, ces dernières sont dimensionnées pour transmettre la modulation de pression à travers la membrane 5, tout en bloquant des gouttes de liquide ou des poussières. Les ouvertures traversantes 5o permettent une communication d'air entre la partie avant 4a et la partie arrière 4r de la cavité 4. Le diamètre des ouvertures traversantes 5o est de préférence compris entre 10 µm et 50 µm, et de préférence entre 10 µm et 30 µm.

Sous l'effet de la présence d'une molécule M dans l'échantillon E, une onde acoustique W, dite onde photoacoustique, est formée. L'onde photoacoustique W est une onde acoustique formée à partir d'un échauffement périodique du milieu par le faisceau lumineux incident L, ce dernier étant impulsionnel ou modulé en amplitude. Une partie de l'onde photoacoustique W s'étend à travers la cavité 4 de façon à être détectée par un transducteur acoustique T. Le transducteur acoustique T est relié à la cavité 4 par un canal acoustique 2_{T} ménagé dans le capot 2_{c}. Le transducteur T acoustique peut être un microphone, présentant une gamme spectrale de détection comprenant la fréquence de l'onde photoacoustique. L'onde photoacoustique est modulée en amplitude selon la fréquence d'impulsion ou de modulation d'amplitude de la source de lumière. Ainsi, au niveau du transducteur acoustique, la pression est modulée en amplitude.

Le dispositif peut comporter un détecteur D, configuré pour détecter une température et/ou un niveau d'humidité relative dans la cavité. Le détecteur D est relié à la cavité 4 par un canal de détection 2_{D} ménagé dans le capot 2c.

Le dispositif peut comporter un évent 2_{E}, ménagé dans le capot 2c, configuré pour relier la cavité 4 à un milieu extérieur, par exemple de l'air ambiant. Un tel évent a été décrit dans US11674931. L'évent peut s'étendre selon une longueur comprise entre 1 mm et 20 mm, et un diamètre compris entre 100 µm et 500 µm.

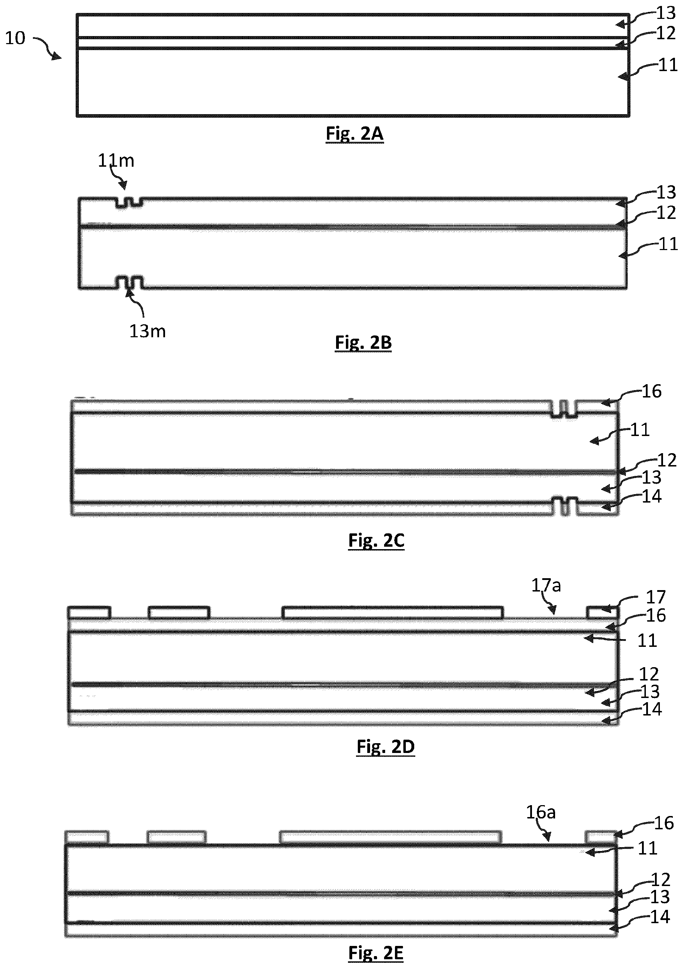

Les figures 2A à 2R montrent les étapes de fabrication d'un premier substrat 10, de façon à former le capot 2c du dispositif. Sur la figure 2A, on a représenté le premier substrat, qui est, dans cet exemple, un substrat de type silicium sur isolant (SOI: Silicon on Insulator), comportant :
- une première couche inférieure 11, dite bulk, de Si, d'épaisseur de quelques centaines de µm, par exemple 725 µm, lorsque le diamètre du substrat est de 200 mm.
- une première couche intermédiaire 12 d'isolant (SiO₂), d'épaisseur de quelques dizaines de nm ou de quelques µm, par exemple 1 ou 2 µm ;
- une première couche supérieure 13 de silicium, et généralement en Si monocristallin, d'épaisseur 225 µm.

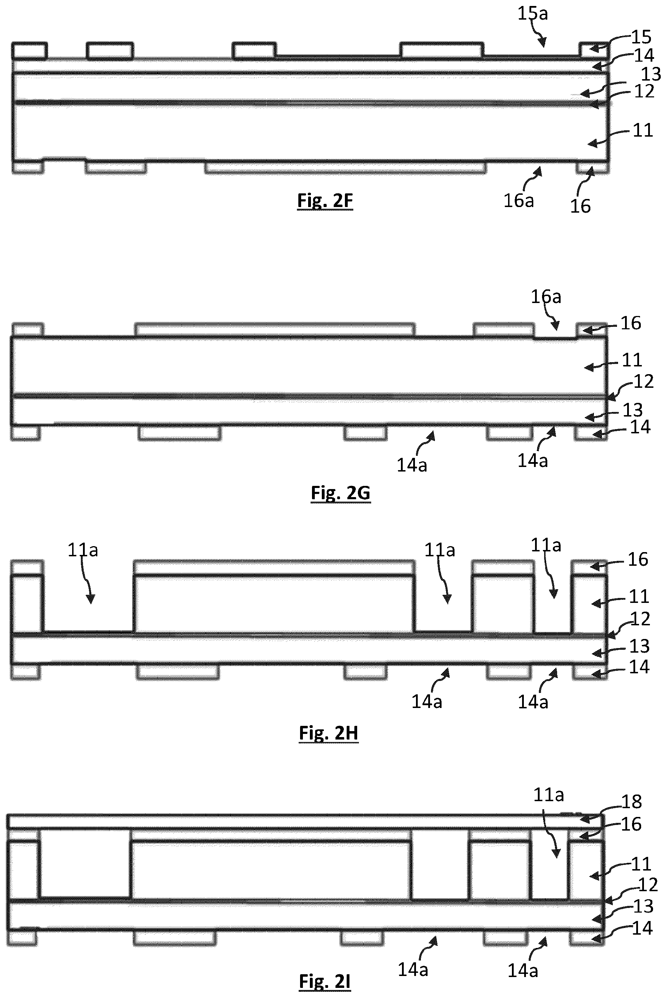

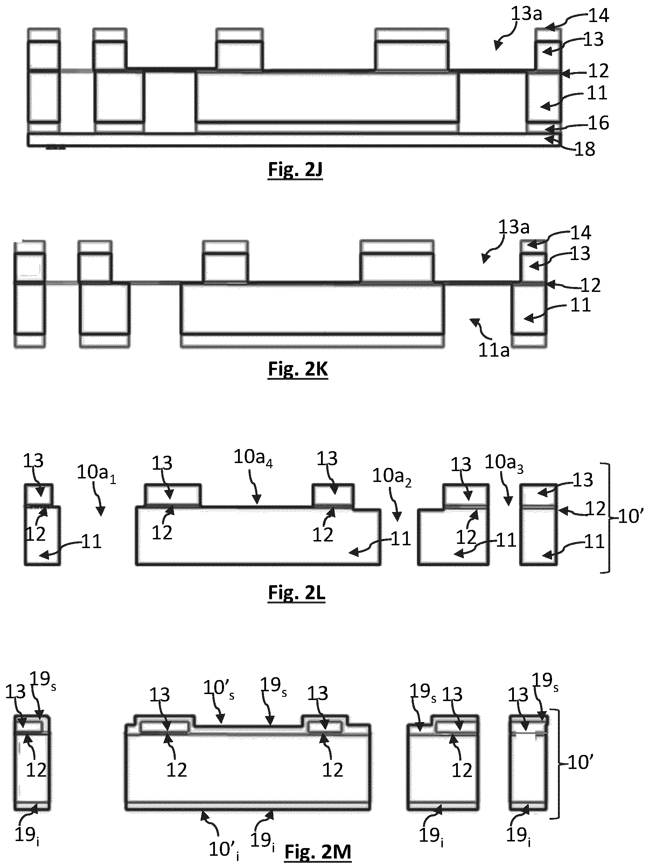

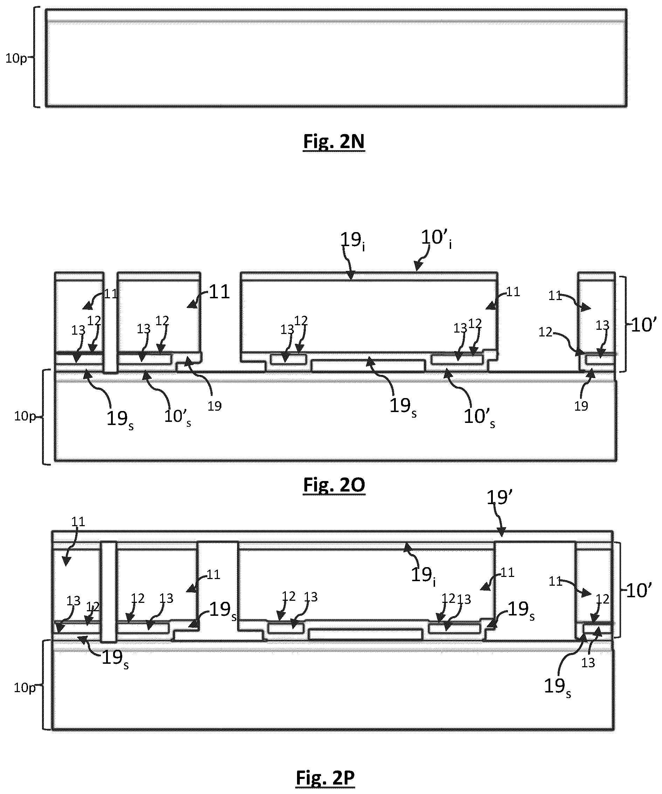

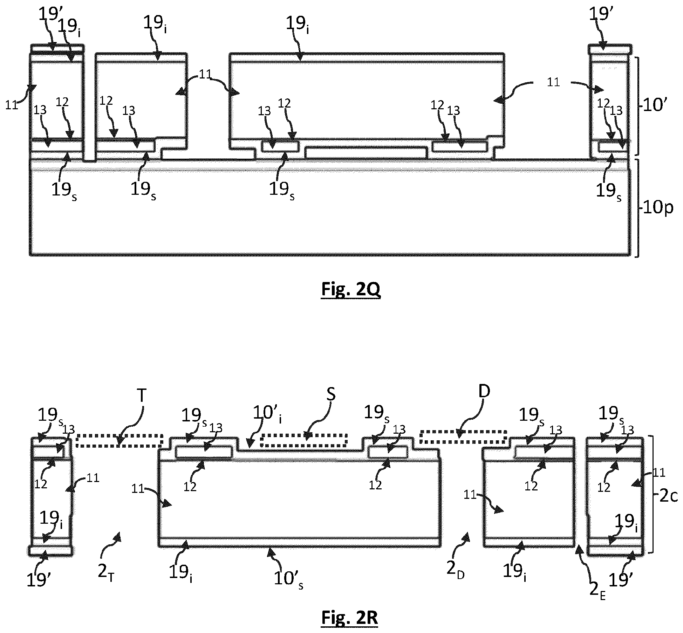

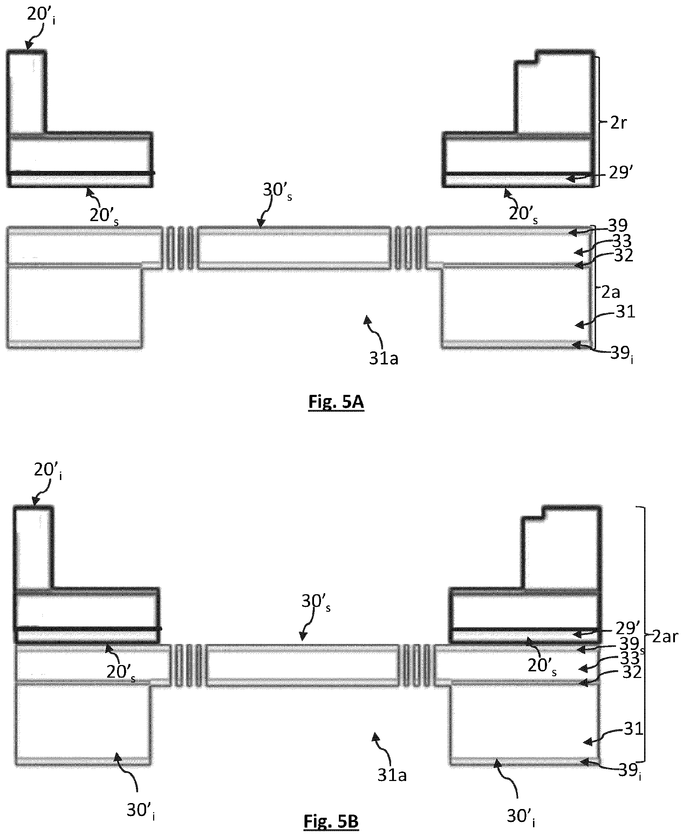

Les étapes de structuration du premier substrat 10 sont, successivement :
- Formation de marques 11m et 13m sur les première couches inférieures et supérieures, par gravure laser. Cf. figure 2B. Ces marques forment des repères permettant un alignement de masques de photolithographie. Ces marques ne sont plus représentées dans les figures suivantes.
- Dépôt d'une couche de SiO2 16 de SiO₂, d'épaisseur comprise entre 3 µm et 5 µm, sur la première couche inférieure 11 et dépôt d'une couche 14 de SiO2, d'épaisseur comprise entre 3 µm et 5 µm, sur la première couche supérieure 13 : cf. figure 2C, la figure 2C étant représenté après retournement du substrat représenté sur la figure 2B.
- Dépôt d'une couche de résine de photolithographie 17 sur la couche 16 puis formation d'un motif par insolation. Le motif définit des ouvertures 17a dans la couche de résine 17 : cf. figure 2D.
- Gravure plasma de la couche 16, de façon à former des ouvertures 16a dans la couche 16, et retrait de la résine 17.Cf. figure 2E
- Retournement du substrat et dépôt d'une couche de résine de photolithographie 15 sur la couche 14 de SiO2 puis formation d'un motif par insolation. Le motif définit des ouvertures 15a dans la couche de résine 15 : cf. figure 2F, sur lequel le substrat a été retourné par rapport à la figure 2E.
- Gravure plasma de la couche 14, de façon à former des ouvertures 14a dans la couche 14, retrait de la résine 15 et retournement du substrat. Cf. figure 2G
- Gravure plasma de la première couche inférieure 11, de façon à former des premières ouvertures inférieures 11a dans cette dernière, à l'aplomb de chaque ouverture 16a. Cf. figure 2H. Les premières ouvertures inférieures 11a sont destinées à former des canaux traversants, tels que le canal acoustique, le canal de détection et l'évent précédemment décrits.
- Dépôt, par laminage, d'un film polymère ( ruban « Revalpha », fabricant Nitto 18, sur la couche 16, refermant les premières ouvertures inférieures 11a pratiquées lors de l'étape précédente. Cf. figure 2I.
- Gravure plasma de la couche 13, de façon à former des premières ouvertures supérieures 13a dans cette dernière, à l'aplomb de chaque ouverture 14a résultant de l'étape décrite en lien avec la figure 2G. Cf. figure 2J, sur laquelle le substrat a été retourné par rapport à la figure 2I. Au cours de la gravure, le film polymère protège un support sur lequel le premier substrat 10 est déposé.
- Retrait du film polymère 18: Cf. figure 2K.
- Retrait, par gravure humide, de la première couche intermédiaire 12 de SiO₂, entre chaque première ouverture inférieure 11a et chaque première ouverture supérieure 13a : cf. figure 2L. Cette étape permet de former 3 canaux traversants 10a1, 10a2, 10a3, correspondant respectivement aux canaux 2_{T}, 2_{D}, 2_{E} décrits en lien avec la figure 1. On obtient ainsi un premier substrat microstructuré 10', qui comporte la structuration nécessaire à la formation du capot 2c du dispositif. Le premier substrat microstructuré 10' s'étend, selon l'épaisseur, entre une première face supérieure 10'ₛ, adjacente de la première couche supérieure 13, et une deuxième face inférieure 10'ᵢ, adjacente de la première couche inférieure 11.
- Dépôt d'une couche 19ₛ, 19ᵢ de Ge-ZnS ; cette couche ayant une fonction antireflet, respectivement sur les premières faces supérieure 10'ₛ et inférieure 10'ᵢ du substrat 10'. Cf. figure 2M. ZnS a une fonction d'antireflet, tandis que Ge favorise l'accroche de ZnS sur le Si. Chaque couche 19ₛ, 19ᵢ est formée d'une épaisseur de 100nm de Ge et d'une épaisseur de 1067nm de ZnS. Le dépôt est effectué à 175°C.
- On utilise ensuite une plaque 10p, formant une poignée, comportant une couche de Si d'épaisseur 550 µm recouverte d'une couche d'un polymère, par exemple le polymère Revalpha précédemment évoqué. De préférence, le polymère utilisé se retire aisément à l'aide d'une action thermique.
- La plaque est représentée sur la figure 2N. La poignée permet une manutention du substrat, par exemple à partir d'un porte substrat.
- Apposition de la plaque 10p contre le substrat 10', du côté de la première face supérieure 10'ₛ : cf. figure 2O, sur laquelle le substrat a été retourné par rapport à la figure 2M.
- Application, par laminage, d'un film adhésif polymère 19', par exemple un film SINR (marque déposée - fournisseur Shin-Etsu MicroSi), d'épaisseur 12µm. Cf. figure 2P. L'ensemble subit un recuit.
- Insolation du film 19', de façon à ne laisser qu'une partie périphérique s'étendant autour des canaux ménagés dans le substrat 10'.Figure 2Q
- Retrait de la poignée 10p : cf. figure 2R. Cette étape permet d'obtenir un substrat, permettant de former, après assemblage par thermocompression, le capot 2c de l'enceinte 2 du dispositif. L'étape d'assemblage est décrite par la suite, en lien avec les figures 5A à 5D. La structuration du premier substrat 10 permet de ménager des emplacements pour disposer le transducteur acoustique T, la source de lumière S et le détecteur de température et/ou d'humidité D. Ces emplacements sont matérialisés par des pointillés sur la figure 2R.

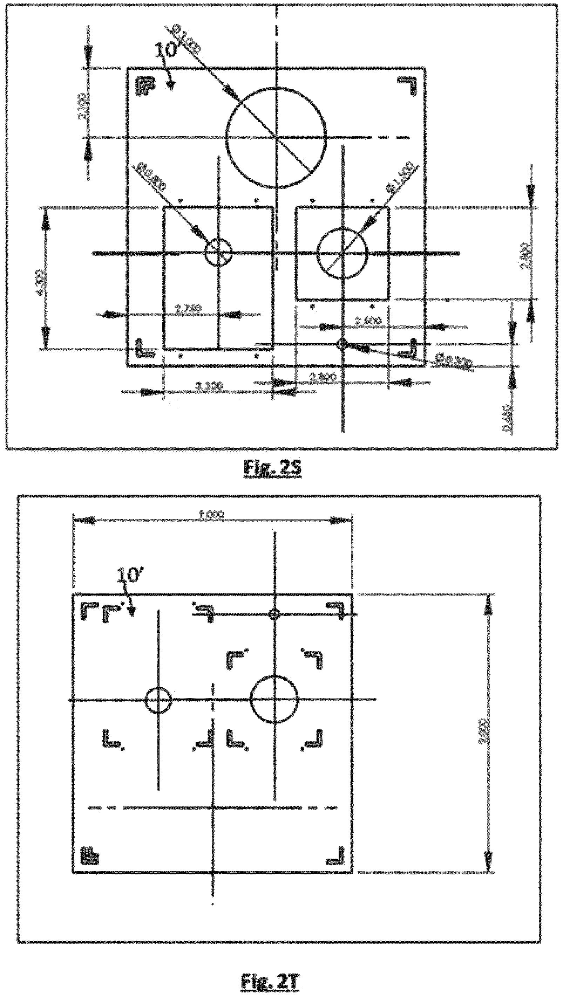

Les figures 2S et 2T représentent respectivement une vue de dessus et de dessous du capot 2c, qui correspond au substrat microstructuré 10'.

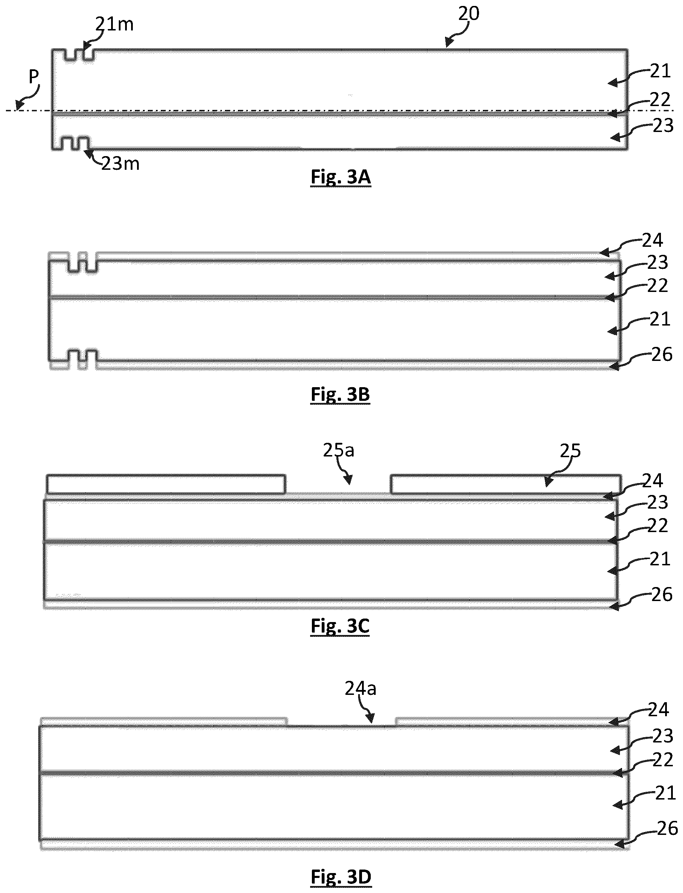

Les figures 3A à 3Q montrent les étapes de fabrication d'un deuxième substrat 20, de façon à former la partie arrière 2r de l'enceinte du dispositif. On utilise un deuxième substrat 20, qui est un substrat de type silicium sur isolant (SOI : Silicon on Insulator), comportant :
- une deuxième couche inférieure 21, dite bulk, de Si, d'épaisseur de quelques centaines de µm, par exemple 725 µm, lorsque le diamètre du substrat est de 200 mm.
- une deuxième couche intermédiaire 22 d'isolant (SiO2), d'épaisseur de quelques dizaines de nm ou de quelques µm, par exemple 1 ou 2 µm ;
- une deuxième couche supérieure 23 de silicium, et généralement en Si monocristallin, d'épaisseur 225 µm.

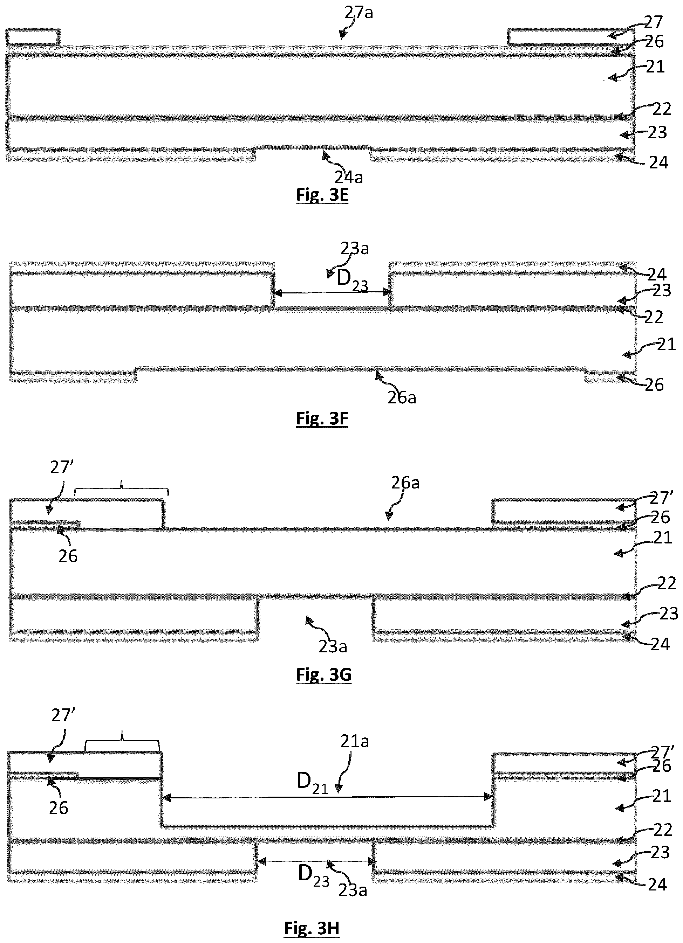

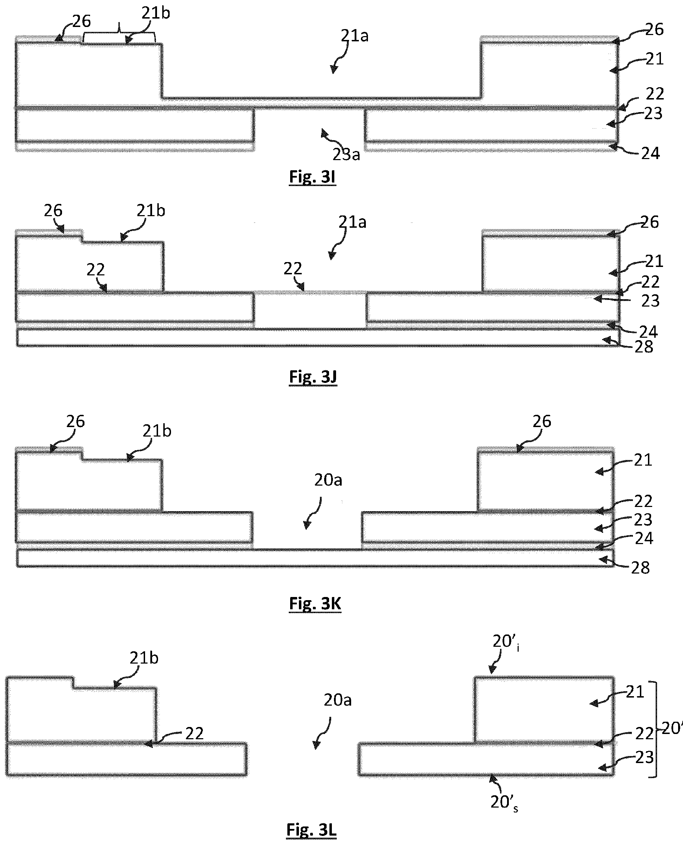

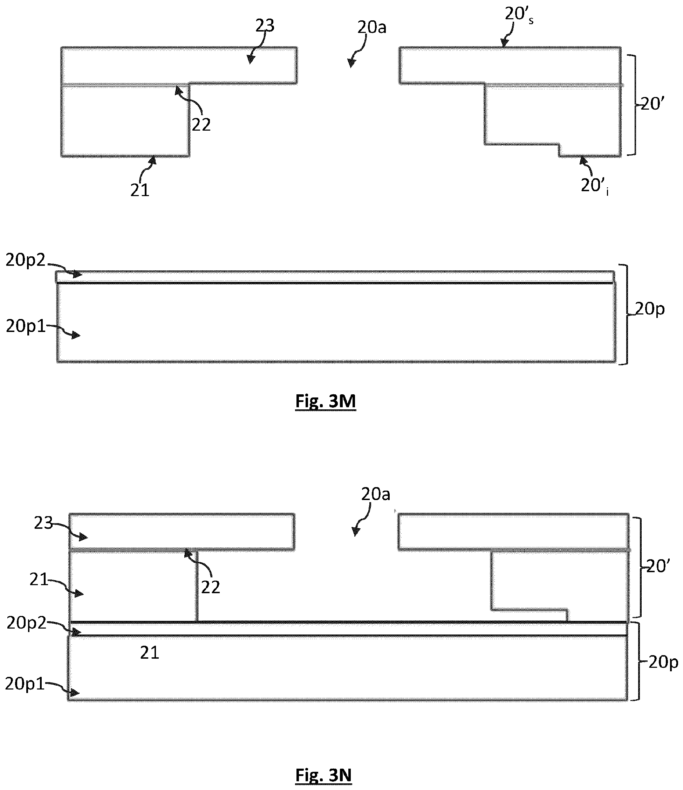

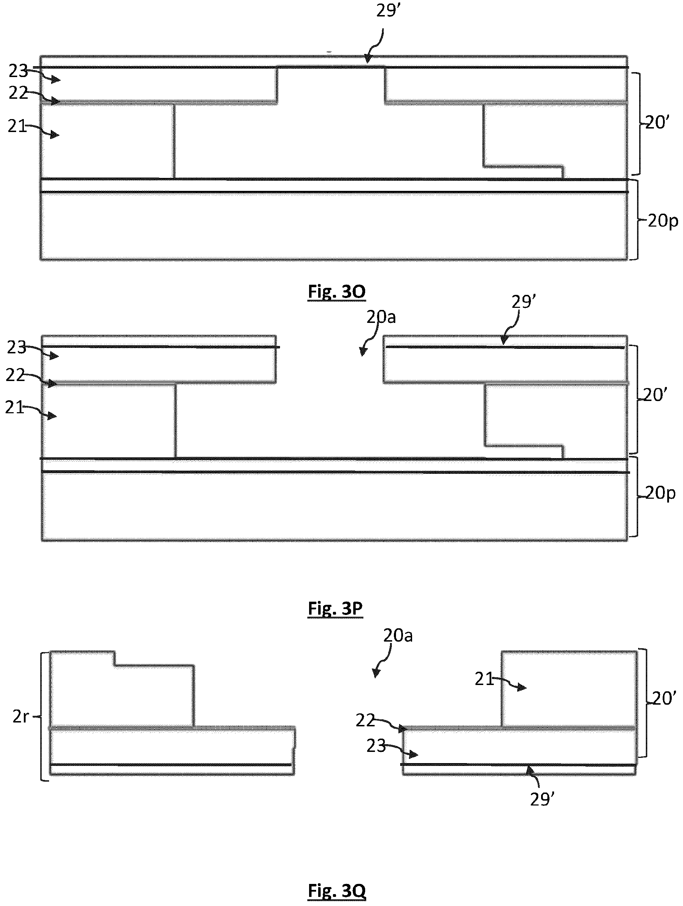

Les étapes de structuration du deuxième substrat 20 sont, successivement :
- Formation de marques 21m et 23m sur les deuxième couches inférieure et supérieure par gravure laser. Cf. figure 3A. Ces marques permettent un alignement de masques de photolithographie. Ces marques ne sont pas représentées par la suite.
- Dépôt d'une couche de 26 SiO₂, d'épaisseur comprise entre 3 µm et 5 µm, sur la deuxième couche inférieure 21 et dépôt d'une couche 24 de SiO₂, d'épaisseur comprise entre 3 µm et 5 µm, sur la deuxième couche supérieure 23 : cf. figure 3B, sur laquelle le deuxième substrat est retourné par rapport à la figure 3A.
- Dépôt d'une couche de résine de photolithographie 25 sur la couche de SiO₂ 24 puis formation, par insolation, d'un motif. Le motif définit une ouverture 25a dans la couche de résine 25 : cf. figure 3C.
- Gravure plasma de la couche 24, de façon à former une ouverture 24a dans la couche 24 et retrait de la résine 25. Cf. figure 3D
- Dépôt d'une couche de résine de photolithographie 27 sur la couche 26 puis formation d'un motif par insolation. Le motif définit une ouverture 27a, plus large que l'ouverture 24a, dans la couche de résine 27 : cf. figure 3E, sur laquelle le deuxième substrat est retourné par rapport à la figure 3D.
- Gravure plasma de la couche 26, de façon à former une ouverture 26a dans la couche 26, puis retrait de la résine 27 et retournement du deuxième substrat et gravure plasma de la deuxième couche supérieure 23, de façon à former une deuxième ouverture supérieure 23a dans cette dernière, à l'aplomb de l'ouverture 24a résultant de l'étape décrite en lien avec la figure 3D. Cf. figure 3F, sur laquelle le deuxième substrat est retourné par rapport à la figure 3E. La désignation « deuxième ouverture supérieure » désigne le fait qu'il s'agit d'une ouverture pratiquée dans la deuxième couche supérieure 23.
   Chaque couche du deuxième substrat s'étend selon un plan principal P, tel que représenté sur la figure 2A. La deuxième ouverture supérieure 23a s'étend, parallèlement au plan principal, selon une dimension supérieure D₂₃.
- Dépôt d'une couche de résine de photolithographie 27' sur la couche 26 subsistant suite à la gravure décrite sur la figure 3F, une partie de la résine 27' recouvrant la première couche 21. Le recouvrement de la couche 21 par la résine 27' est matérialisé par une accolade. Insolation de la résine 27', de façon à former une ouverture 27'a dans la couche 27'. Cf. figure 3G, sur laquelle le deuxième substrat est retourné par rapport à la figure 3F.
- Gravure partielle plasma de la deuxième couche inférieure 21, de façon à former une deuxième ouverture inférieure 21a dans cette dernière, à l'aplomb de l'ouverture 27'a résultant de l'étape décrite dans l'étape précédente. Cf. figure 3H. Les ouvertures 21a et 23a sont destinées à former la partie arrière de la cavité. La désignation « deuxième ouverture inférieure » désigne le fait qu'il s'agit d'une ouverture pratiquée dans la deuxième couche inférieure 21. La deuxième ouverture inférieure 21a s'étend, parallèlement au plan principal, selon une dimension inférieure D₂₁. De préférence, D₂₁ > D₂₃.
- Retrait de la résine 27' cf. figure 3I.
- Gravure complémentaire de la couche 21, jusqu'à la couche 22. Cela permet de former un décroché 21b sur la couche 21. Puis dépôt, par laminage, d'un film polymère 28, sur la couche 24. Cf. figure 3J. Le film polymère 28 est du même type que le film 18 précédemment décrit.
- Retrait, par gravure humide, de la couche 22 de SiO₂ : cf. figure 3K. Cette étape permet de former une ouverture traversante 20a.
- Retrait du film polymère 28: Cf. figure 3L. On obtient ainsi un deuxième substrat microstructuré 20', qui comporte la structuration nécessaire à la formation de la partie arrière de l'enceinte 2r. Le deuxième substrat microstructuré 20' s'étend, selon l'épaisseur, entre une deuxième face supérieure 20'ₛ, adjacente de la deuxième couche supérieure 23, et une deuxième face inférieure 20'ᵢ, adjacente de la deuxième couche inférieure 21.
- On utilise ensuite une plaque 20p, formant une poignée, comportant une couche 20p2 de Si d'épaisseur 550µm recouverte d'une couche d'un polymère 20p1. La plaque est apposée contre la deuxième face inférieure 20'ᵢ du deuxième substrat 20' cf. figures 3M et 3N. Sur la figure 3M, le deuxième substrat est retourné par rapport à la figure 3L.
- Application, par laminage, d'un film adhésif polymère 29' sur la deuxième couche supérieure 23. Le film adhésif peut par exemple être un film SINR (marque déposée - fournisseur Shin-Etsu MicroSi) d'épaisseur 12µm, puis recuit. Cf. figure 3O
- Insolation du film 29', de façon à ne laisser qu'une partie périphérique s'étendant autour de l'ouverture 20a du substrat 20', puis recuit. Cf. figure 3P
- Retrait de la poignée 20p: figure 3Q, sur laquelle le deuxième substrat est retourné par rapport à la figure 3P. Cette étape permet d'obtenir la partie arrière 2r de l'enceinte, après assemblage par thermocompression. L'ouverture traversante 20a forme la partie arrière 4r de la cavité 4. L'étape d'assemblage est décrite par la suite, en lien avec les figures 5A à 5C.

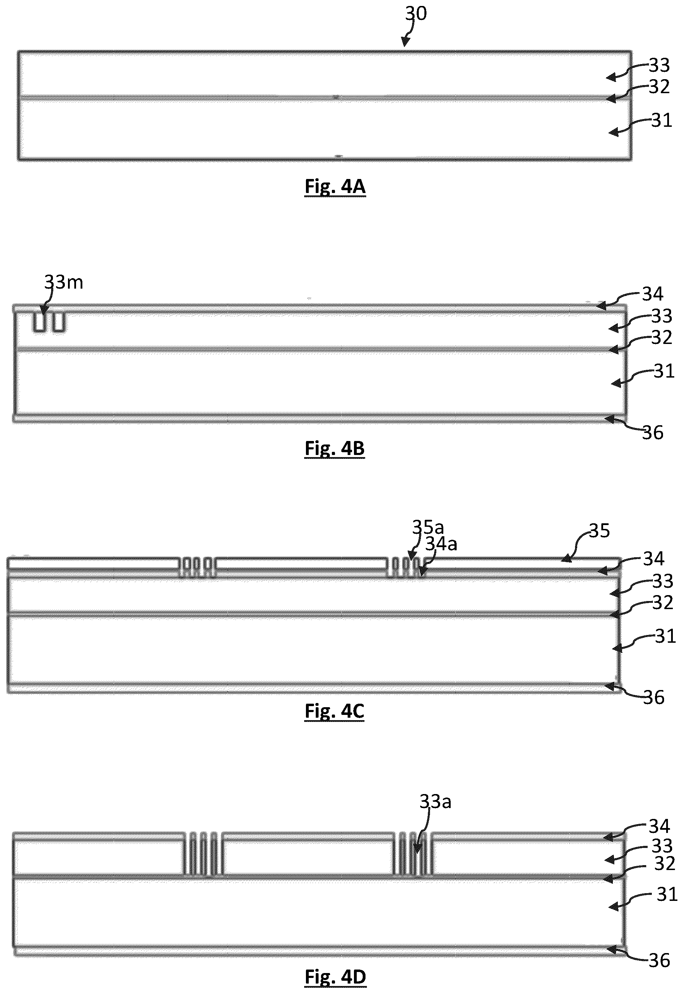

Les figures 4A à 4J montrent les étapes de fabrication d'un troisième substrat 30, de façon à former la partie avant 2a de l'enceinte du dispositif. On utilise un troisième substrat 30, comportant une troisième couche inférieure 31, une troisième couche intermédiaire 32 et une troisième couche supérieure 33 respectivement similaires aux couches inférieures, intermédiaire et supérieure des premier et deuxième substrats précédemment décrits. Cf. figure 4A.

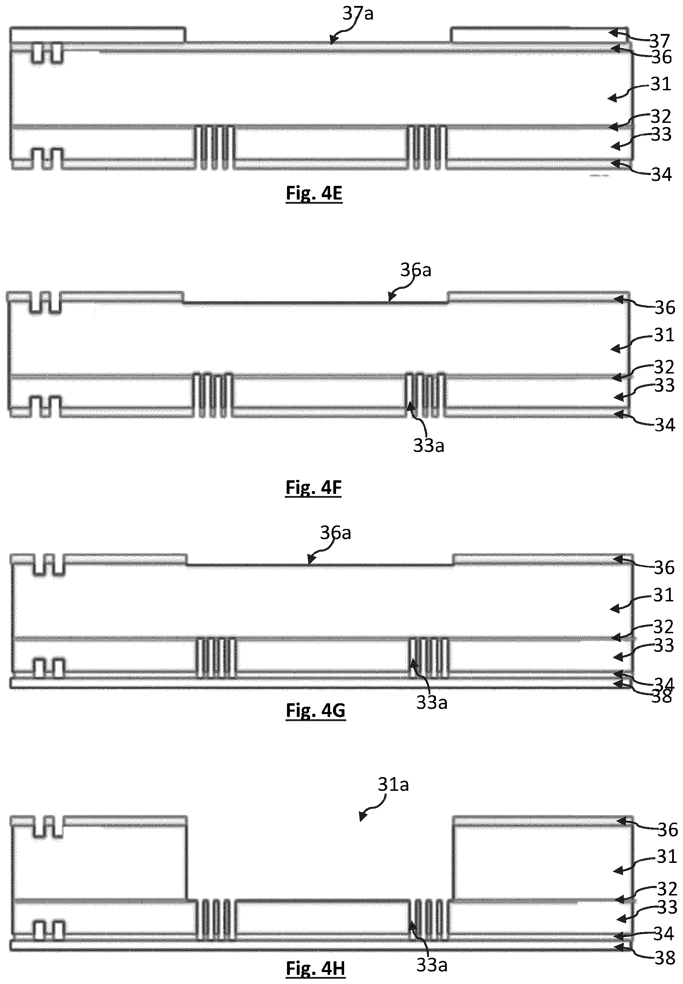

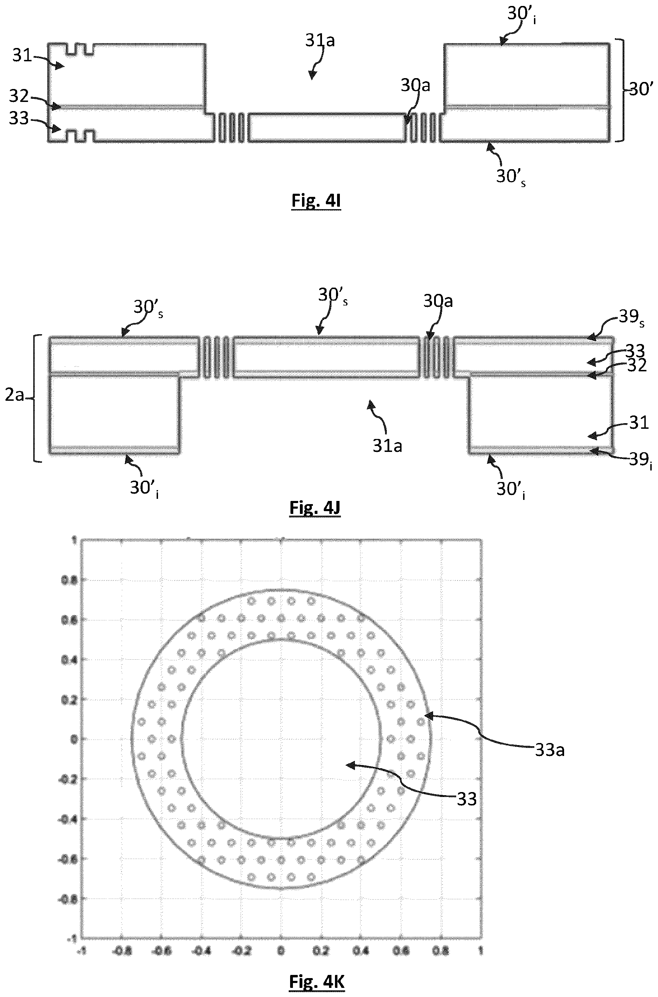

Les étapes de structuration du troisième substrat 30 sont, successivement :
- Formation de repères 33m sur la troisième couche supérieure par gravure laser. Ces repères permettent un alignement de masques de photolithographie. Puis dépôt d'une couche 36 de SiO2, d'épaisseur comprise entre 3 µm et 5 µm, sur la troisième couche inférieure 31 et dépôt d'une couche 34 de SiO2, d'épaisseur comprise entre 3 µm et 5 µm, sur la troisième couche supérieure 33 : cf. figure 4B
- Dépôt d'une couche de résine de photolithographie 35 sur la couche 34 de SiO2 puis formation, par insolation, d'un motif. Le motif définit des ouvertures 35a dans la couche de résine 35. Puis gravure plasma de la couche 34, de façon à former des ouvertures 34a dans la couche 34. Cf. figure 4C. Il s'agit d'amorcer la formation d'ouvertures traversantes dans la couche 33, de façon à former la membrane 5 décrite en lien avec la figure 1.
- Gravure plasma de la couche supérieure 33, de façon à former des ouvertures 33a dans cette dernière, à l'aplomb de chaque ouverture 34a résultant de l'étape précédente. Cf. figure 4D. Les étapes représentées sur les figures 4C et 4D sont optionnelles.
- Dépôt d'une couche de résine de photolithographie 37 sur la couche 36 puis formation d'un motif par insolation. Le motif définit une ouverture 37a. Cf. figure 4E, sur laquelle le troisième substrat est retourné par rapport à la figure 4D.
- Gravure plasma de la couche 36, de façon à former une ouverture 36a dans la couche 36, puis retrait de la résine 37. Cf. figure 4F
- Dépôt, par laminage, d'un film polymère 38, sur la couche 34. Cf. figure 4G. Le film 38 est du même type que les films 18 et 28 précédemment décrits.
- Gravure plasma de la couche inférieure 31, de façon à former une ouverture 31a dans cette dernière, à l'aplomb de l'ouverture 36a résultant de l'étape décrite en lien avec la figure 4F. Cf. figure 4H.
- Retrait du film polymère 38. Cf. figure 4I. On obtient ainsi un troisième substrat microstructuré 30', qui comporte la structuration nécessaire à la formation de la partie avant 2a de l'enceinte. Le troisième substrat microstructuré 30' s'étend, selon l'épaisseur, entre une troisième face supérieure 30'ₛ, adjacente de la troisième couche supérieure 33, et une troisième face inférieure 30'ᵢ, adjacente de la troisième couche inférieure 31.
- Dépôt d'une couche antireflet 39ₛ, 39ᵢ de Ge-ZnS comportant une épaisseur de 100nm de Ge et de 1067nm de ZnS sur la troisième face supérieure et la troisième face inférieure du substrat 30' respectivement. Cf. figure 4J. Cette étape permet d'obtenir la partie avant 2a de l'enceinte 2 du dispositif, comportant la membrane.

La figure 4K montre une vue de dessus du substrat 30' : on observe les ouvertures traversantes 30a, qui correspondent, après assemblage, aux ouvertures 5o de la membrane. Dans cet exemple, les ouvertures traversantes ont un diamètre de 30 µm, l'espacement entre deux ouvertures adjacentes étant de 100 µm. Sur la figure 4K, l'unité de chaque axe est le millimètre.

Dans le mode de réalisation représenté sur les figures 4A à 4K, la membrane comporte des ouvertures et est disposée en retrait de la face de contact. La membrane délimite une partie avant de la cavité, creuse : la partie avant de la cavité s'étend entre la face de contact et la membrane. Selon une variante, la gravure de la troisième couche inférieure 31 est telle que suite à l'étape représentée sur la figure 4H, la membrane affleure la face de contact. Selon cette variante, il est préférable que la membrane ne soit pas creuse : elle est destinée à être disposée au contact, ou au quasi-contact, par exemple à moins de 1 mm ou moins de 500 µm ou moins de 100 µm, de l'échantillon.

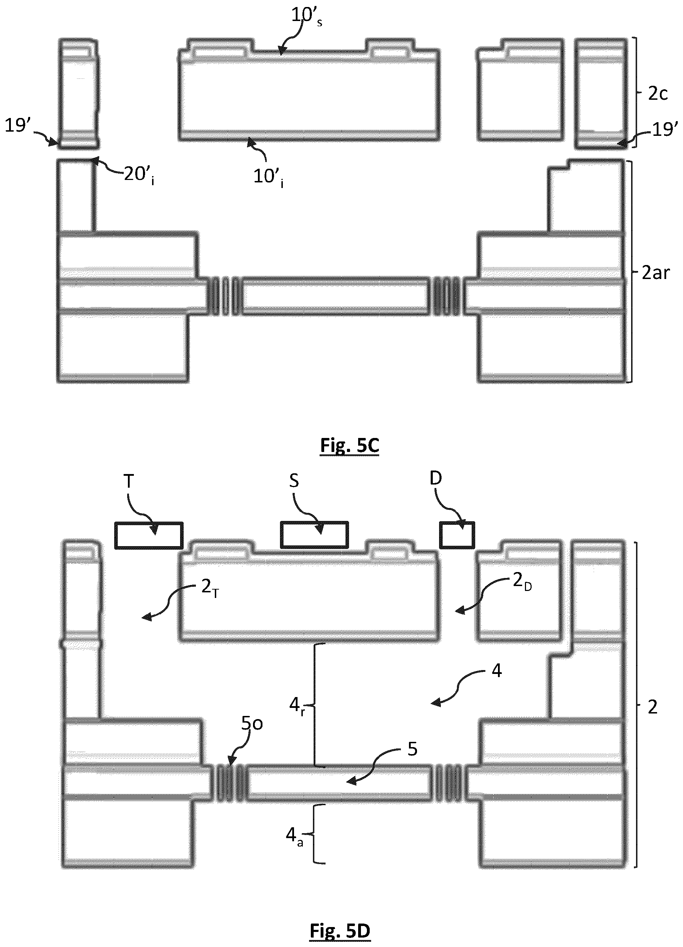

Les figures 5A à 5D montrent les étapes d'assemblage, par thermocompression, qui permettent de former l'enceinte 2 du dispositif représenté sur la figure 1, par :
- assemblage de la partie arrière 2r sur la partie avant 2a : la deuxième face supérieure 20'ₛ du deuxième substrat 20' est accolée, par le polymère 29', à la troisième face supérieure 30's du troisième substrat 30' : cf. figures 5A et 5B : on obtient un substrat 2ar ;
- assemblage du capot 2c sur le substrat 2ar : la deuxième face inférieure 20'ᵢ du deuxième substrat 20' est accolée, par le polymère 19', à la première face inférieure 10'i du premier substrat 30' cf. figures 5C et 5D : on obtient un substrat assemblé, formant l'enceinte 2 du dispositif. Sur la figure 5D, on a représenté les principales composantes de l'enceinte, telles que décrites en lien avec la figure 1. On a également schématisé l'emplacement du transducteur T, de la source de lumière S et du détecteur D.

Chaque assemblage est effectué, par exemple, par thermocompression, au moyen de l'adhésif polymère 19', 39'. D'autres adhésifs peuvent être utilisés, organiques ou inorganiques.

L'ordre de l'assemblage peut être interverti.

Le procédé décrit ci-avant peut être répliqué sur même substrat, en parallèle, de façon à former simultanément plusieurs enceintes 2. On obtient ainsi plusieurs enceintes 2, qui peuvent être séparées les unes des autres, après l'ensemble des étapes de fabrication, selon un procédé de type pick and place (prendre et placer). Le collage peut être effectué en mode wafer level (collage plaque à plaque), ou collage die to wafer (puce à plaque) ou flip-chip (puce sur puce).

Le recours à des procédés de microfabrication permettent d'obtenir un dispositif compact, compatible avec une intégration dans un objet nomade, par exemple une montre connectée. Le volume de l'enceinte 2 peut être de l'ordre de quelques dixièmes de cm³. Le procédé peut être mis en œuvre à partir de substrats silicium standards.

Le recours à un assemblage par thermocompression, en utilisant un polymère permet de s'affranchir des difficultés liées au collage métallique, dont le rendement est faible, et dépend de l'état de surface des surfaces assemblées. Selon des alternatives, l'assemblage des trois substrats peut être réalisé par collage métallique de type Ti-Ti ou Au-Au. Dans ce cas, les parties destinées à être assemblées sont métalliques.

Le recours à trois substrats indépendants permet une modification de l'un d'entre eux, sans influer sur la fabrication des autres. Par exemple, le premier substrat, formant le capot, peut être modifié, tout en restant compatible avec les deuxième et troisième substrats, formant les parties arrière et avant de l'enceinte. De la même façon, la configuration de la membrane (3^{ième} substrat), peut être modifiée tout en restant compatible avec les premier et deuxième substrats, formant le capot et la partie arrière de l'enceinte.

Le recours à trois substrats indépendants permet également d'envisager une fabrication en parallèle.

Bien que décrit en lien avec des substrats SOI, ce qui correspond à une configuration avantageuse car chaque couche intermédiaire d'isolant peut être utilisée en tant que couche d'arrêt de gravure, le recours à d'autres types de substrats, de type « bulk » (brut), est envisageable.

## Revendications

1. Procédé de fabrication d'une enceinte (2) délimitant une cavité (4), creuse, l'enceinte étant destinée à être appliquée contre un échantillon à analyser (E), la cavité étant configurée pour s'étendre entre l'échantillon et un transducteur acoustique (T), la cavité débouchant sur une face de contact (3) destinée à être appliquée contre l'échantillon, l'enceinte comportant :
- une ouverture de contact (3o), ménagée dans la face de contact, débouchant dans la cavité ;
- une membrane (5) s'étendant à travers la cavité, en regard de la face de contact, de façon que tout ou partie de la cavité s'étend entre la membrane et un capot (2c) ;
le procédé comportant les étapes :
- 1) microstructuration d'un premier substrat (10), de façon à former le capot (2c);
- 2) microstructuration d'un deuxième substrat (20), de façon à former une partie arrière de l'enceinte (2r), délimitant tout ou partie de la cavité, entre la membrane et le capot ;
- 3) microstructuration d'un troisième substrat (30), de façon à former une partie avant (2a) de l'enceinte, comportant la membrane ;
- 4) assemblage du capot (2c) sur la partie arrière de l'enceinte (2r), et de la partie arrière de l'enceinte (2r) sur la partie avant de l'enceinte (2a).

2. Procédé selon la revendication 1, dans lequel la membrane (3) sépare la cavité entre une partie arrière de la cavité (4r) et une partie avant de la cavité (4a), la partie avant de la cavité débouchant sur la face de contact, la membrane étant disposée entre la partie avant de la cavité et la partie arrière de la cavité, le procédé étant tel que :
- l'étape 2) comporte une formation de la partie arrière de la cavité ;
- l'étape 3) comporte une formation de la partie avant de la cavité.

3. Procédé selon l'une quelconque des revendications précédentes, dans lequel l'étape 1) comporte une formation d'un canal acoustique (2_{T}) s'étendant à travers le capot, destiné à relier la cavité au transducteur acoustique.

4. Procédé selon l'une quelconque des revendications précédentes, dans lequel l'étape 1) comporte une formation d'un évent (2_{E}) s'étendant à travers le capot, destiné à relier la cavité à un milieu extérieur à cette dernière.

5. Procédé selon l'une quelconque des revendications précédentes, dans lequel l'étape 1) comporte une formation d'un canal de détection (2_{D}), s'étendant à travers le capot, destiné à relier la cavité à un capteur de température et/ou d'humidité

6. Procédé selon l'une quelconque des revendications 1 ou 2, et de l'une quelconque des revendications 3 à 5, dans lequel :
- le premier substrat comporte une première couche supérieure (13), une première couche intermédiaire (12), de type isolant, et une première couche inférieure (11);
- l'étape 1) comporte
• 1i) gravure de la première couche inférieure, de façon à former au moins une première ouverture inférieure (11a), la première couche intermédiaire faisant office de couche d'arrêt de gravure ;
• 1ii) gravure de la première couche supérieure, de façon à former au moins une première ouverture supérieure (13a), la première couche intermédiaire faisant office de couche d'arrêt de gravure ;
• 1iii) retrait de la première couche intermédiaire, respectivement entre chaque première ouverture inférieure formée lors de la sous-étape 1i) et chaque première ouverture supérieure formée lors de la sous-étape 1ii), de façon à former un canal, choisi parmi le canal acoustique, l'évent ou le canal de détection.

7. Procédé selon l'une quelconque des revendications précédentes, dans lequel :
- le deuxième substrat comporte une deuxième couche supérieure (23), une deuxième couche intermédiaire (22), et une deuxième couche inférieure (21);
- l'étape 2) comporte les sous-étapes suivantes
• 2i) gravure de la deuxième couche supérieure, de façon à former une deuxième ouverture supérieure (23a), la deuxième couche intermédiaire faisant office de couche d'arrêt de gravure ;
• 2ii) gravure de la deuxième couche inférieure, de façon à former une deuxième ouverture inférieure (21a), la deuxième couche intermédiaire faisant office de couche d'arrêt de gravure ;
• 2iii) retrait de la deuxième couche intermédiaire, respectivement entre la deuxième ouverture supérieure formée lors de la sous-étape 2i) et la deuxième ouverture inférieure formée lors de la sous-étape 2ii), de façon à former tout ou partie de la cavité.

8. Procédé selon la revendication 7, dans lequel :
- le deuxième substrat s'étend parallèlement à un plan principal (P);
- lors de l'étape 2i), la gravure est réalisée, à travers la deuxième couche supérieure, selon une dimension supérieure (D₂₃) , dans le plan principal ;
- lors de l'étape 2ii), la gravure est réalisée, à travers la deuxième couche inférieure, selon une dimension inférieure (D₂₁), dans le plan principal ;
- la dimension inférieure est plus élevée que la dimension supérieure.

9. Procédé selon l'une quelconque des revendications 7 ou 8, dans lequel l'épaisseur de la deuxième couche inférieure est plus élevée que l'épaisseur de la deuxième couche supérieure.

10. Procédé selon l'une quelconque des revendications 7 à 9, et selon la revendication 2, dans lequel au cours de l'étape 2iii), le retrait de la deuxième couche intermédiaire forme la partie arrière de la cavité.

11. Procédé selon l'une quelconque des revendications précédentes, dans lequel :
- le troisième substrat comporte une troisième couche supérieure (33), une troisième couche intermédiaire (32) et une troisième couche inférieure (31);
- l'étape 3) comporte :
• 3i) gravure de la troisième couche inférieure, de façon à former une partie avant de l'enceinte, la troisième couche intermédiaire faisant office de couche d'arrêt de gravure, la troisième couche supérieure formant la membrane.

12. Procédé selon la revendication 11, et selon la revendication 2, dans lequel au cours de l'étape 3i), la gravure de la troisième couche inférieure forme la partie avant de la cavité (4a).

13. Procédé selon l'une quelconque des revendications précédentes, dans lequel la membrane est traversée par des ouvertures, le procédé comportant :
- 3ii) gravure de la troisième couche supérieure, la troisième couche intermédiaire faisant office de couche d'arrêt de gravure, la gravure de la troisième couche supérieure étant configurée pour former une pluralité de troisièmes ouvertures s'étendant à travers la troisième couche supérieure ;
- 3iii) retrait de la troisième couche intermédiaire, au niveau de chaque troisième ouverture résultant de la sous-étape 3ii), de façon que chaque troisième ouverture soit traversante.

14. Enceinte (2), délimitant une cavité (4), l'enceinte étant destinée à être appliquée contre un échantillon à analyser (E), la cavité étant configurée pour s'étendre entre l'échantillon et un détecteur acoustique, la cavité débouchant sur une face de contact (3) destinée à être appliquée contre l'échantillon, l'enceinte comportant :
- une ouverture de contact (3o) , ménagée dans la face de contact, débouchant dans la cavité ;
- une membrane (5) s'étendant à travers la cavité, en regard de la face de contact, de façon que tout ou partie de la cavité s'étend entre la membrane et un capot (2c);
l'enceinte étant fabriquée en mettant en œuvre les étapes 1) à 4) d'une quelconque des revendications précédentes.

15. Dispositif comportant une enceinte (2), délimitant une cavité (4), l'enceinte étant destinée à être appliquée contre un échantillon à analyser (E), le dispositif comportant :
- une face de contact, débouchant dans la cavité, et destinée à être appliquée contre l' échantillon ;
- une source de lumière (S), configurée pour émettre une lumière impulsionnelle ou modulée en amplitude à travers l'enceinte, vers la face de contact ;
- un transducteur acoustique, relié à la cavité ;
le dispositif étant tel que l'enceinte est une enceinte selon la revendication 14.
